# EUROPÄISCHE PATENTSCHRIFT

(11) **EP 4 207 956 B1**
(45) Veröffentlichungstag und Bekanntmachung des Hinweises auf die Patenterteilung: **03.07.2024**
(21) Anmeldenummer: 21217902.2
(22) Anmeldetag: 28.12.2021
(51) Int. Cl.: H05K 3/46, H05K 3/28, H05K 1/02, H05K 1/18

(54) **FAHRZEUGSCHEINWERFERMODUL**
MODULE FOR VEHICLE HEADLAMP
MODULE DE PHARE DE VÉHICULE

(43) Veröffentlichungstag der Anmeldung: 05.07.2023
(73) Patentinhaber: ZKW Group GmbH, 3250 Wieselburg (AT)
(72) Erfinder: Csaky-Pallavicini, Carl, 2500 Baden (AT); Seibert, Dominic, 2344 Maria Enzersdorf (AT)
(74) Vertreter: Patentanwaltskanzlei Matschnig & Forsthuber OG

(56) Entgegenhaltungen:
- DE-A1-102005 001 146
- DE-A1-102007 042 593
- DE-A1-102009 060 780

## Beschreibung

Die Erfindung betrifft ein Fahrzeugscheinwerfermodul, umfassend eine elektrische Schaltungsanordnung zur Steuerung zumindest einer Funktion eines Fahrzeugscheinwerfers, sowie ein Gehäuse zur zumindest teilweisen Aufnahme der elektrischen Schaltungsanordnung, wobei das Gehäuse zumindest abschnittsweise eine der Schaltungsanordnung zugewandte metallische elektrisch leitfähige Abschirmungsoberfläche zur elektromagnetischen Abschirmung der Schaltungsanordnung aufweist, wobei die elektrische Schaltungsanordnung zumindest einen weitgehend eben ausgebildeten kontaktsensiblen Oberflächenabschnitt aufweist, wobei dieser kontaktsensible Oberflächenabschnitt frei von daran angeordneten elektrischen Bauteilen ist und einem ebenen Abschnitt der Abschirmungsoberfläche des Gehäuses zugewandt ist, wobei elektrische Leiterbahnen und/oder Kontakte entlang dem kontaktsensiblen Oberflächenabschnitt verlaufen.

Der Einbau der Schaltungsanordnung in dem Fahrzeugscheinwerfermodul soll in der Regel möglichst platzsparend erfolgen. Zur elektromagnetischen Abschirmung von Schaltungsanordnungen ist es üblich, diese zumindest abschnittsweise mit einem elektrisch leitfähigen Gehäuse zu umschließen. Im Stand der Technik besteht dabei das Problem, dass die Schaltungsanordnung dabei nicht beliebig nahe an das elektrisch leitfähige Gehäuse herangerückt werden kann, da ansonsten die Gefahr des Auftretens elektrischer Kurzschlüsse durch Oberflächenkontakt mit einer elektrisch leitfähigen Fläche besteht. Zwar ist das Auftragen einer Isolierlackschicht auf Oberflächen von Schaltungsanordnungen hinreichend bekannt und dazu geeignet, einen Kurzschluss bei einem Oberflächenkontakt mit einer elektrisch leitfähigen Fläche zu verhindern, allerdings besteht bei Fahrzeuganwendungen das zusätzliche Problem, dass Fahrzeugscheinwerfermodule während des Fahrbetriebs häufig mechanischen Einflüssen wie Vibrationen und Erschütterungen ausgesetzt sind, die zu einem Abscheuern einer elektrische Kontaktbereiche oder Leiterbahnen überziehenden Isolierschicht führen können. Kurzschlüsse können als Folge davon auftreten. Das Bestehen von Fertigungstoleranzen und Einbautoleranzen verursacht Positionsungenauigkeiten der Lage der Schaltungsanordnung sowie des Gehäuses, sodass es erforderlich ist, schon bei der Planung eines Fahrzeugscheinwerfermoduls einen Puffer bei der Wahl des minimalen Sicherheitsabstands der Schaltungsanordnung zu dem umgebenden elektrisch leitfähigen Gehäuse bzw. Abschirmungselement einzukalkulieren, um das Auftreten von Kurschlüssen in Folge von unerwünschtem Gehäusekontakt zu vermeiden.

Relevanter Stand der Technik ist in der Patentschrift DE 10 2009 060780 A1 offenbart.

Eine Aufgabe der Erfindung besteht daher darin ein Fahrzeugscheinwerfermodul zu schaffen, das eine platzsparende Bauweise bei weiterhin hoher Betriebssicherheit ermöglicht. Diese Aufgabe wird durch ein Fahrzeugscheinwerfermodul der eingangs genannten Art gelöst, bei welchem erfindungsgemäß an dem weitgehend eben ausgebildeten kontaktsensiblen Oberflächenabschnitt eine Anzahl ausgehärteter elektrisch nicht leitfähiger Klebepunkte angeordnet ist, die von dem kontaktsensiblen Oberflächenabschnitt zur Sicherstellung eines Mindestabstandes zwischen dem kontaktsensiblen Oberflächenabschnitt und dem ebenen Abschnitt der Abschirmungsoberfläche des Gehäuses in Richtung des ebenen Abschnitts der Abschirmungsoberfläche des Gehäuses abstehen. Auf diese Weise wird verhindert, dass der kontaktsensible Oberflächenabschnitt an dem ebenen Abschnitt der Abschirmungsoberfläche scheuert, selbst wenn die Schaltungsanordnung so nah an der Abschirmungsoberfläche angeordnet ist, dass die Klebepunkte diese zumindest zeitweise kontaktieren. Die Erfindung ermöglicht dadurch eine besonders platzsparende Bauweise bei gleichbleibend hoher Betriebssicherheit.

Die ausgehärteten Klebepunkte sind während des üblichen Bestückungsprozesses (typischerweise in SMT-Technologie) auf die Schaltungsanordnung aufbringbar und können z.B. im Zuge und/oder bereits vor der Durchführung eines Lötvorganges in einem sogenannten Reflow-Lötofen aushärten.

Klebematerial und Vorrichtungen zur Aufbringung von Klebepunkten sind bei einem Bestückungsprozess von Schaltungsanordnungen für Fahrzeugmodule häufig verfügbar, und zwar beispielsweise um positionskritische Bauteile wie LED-Lichtquellen in ihrer Lage zu fixieren, bevor an der Schaltungsanordnung angeordnete Lötpaste, auf der die positionskritischen Bauteile nach der Bestückung aufsitzen, zur Herstellung einer dauerhaften elektrischen Verbindung in einem Lötvorgang aufgeschmolzen wird. Die klebenden Eigenschaften des Klebepunkte sind daher insofern relevant, als dass diese Punkte einfach, formstabil und positionssicher auf die Schaltungsanordnung angebracht werden können und nach ihrer Aushärtung fest an der Schaltungsanordnung haften. Die Klebepunkte wirken nach ihrer Aushärtung als Abstandshalter und weisen typischerweise eine punktförmige Geometrie auf, da sie punktförmig durch einen Dispenser in einem Assemblierungs-Prozess auf die Schaltungsanordnung dispensiert und danach im Zuge des SMT-Lötvorganges in einem Lötofen ausgehärtet werden können.

Die elektrische Schaltungsanordnung ist zur Steuerung zumindest einer Funktion eines Fahrzeugscheinwerfers eingerichtet. Dabei kann es sich z.B. um eine oder mehrere der folgenden genannten Lichtfunktionen handeln: Fernlicht, Matrixlicht, Abblendlicht, Parklicht, Heckbeleuchtung, etc. Als elektrische Bauteile kommen beliebige elektrische Komponenten in Betracht, die bei Fahrzeugscheinwerfermodulen eingesetzt werden können. Beispielhaft seien ICs, Kondensatoren, Spulen, Widerstände, Dioden, usw. genannt. Die elektrischen Leiterbahnen und/oder Kontakte, die entlang dem kontaktsensiblen Oberflächenabschnitt angeordnet sind, können auch von einer isolierenden Schicht, z.B. von einer Lötstopplackschicht, überzogen sein. Der Ausdruck, wonach "an dem weitgehend eben ausgebildeten kontaktsensiblen Oberflächenabschnitt eine Anzahl elektrisch nicht leitfähiger Klebepunkte angeordnet ist" bedeutet, dass der Oberflächenabschnitt dergestalt eben ausgebildet ist, dass abstehenden Klebepunkte den Oberflächenabschnitt überragen, und zwar so, dass auch etwaige geringfügige Unebenheiten in der Oberfläche von den Klebepunkten überragt werden, sodass im Fall eines Kontaktes mit einer parallel orientierten ebenen metallischen elektrisch leitfähigen Abschirmungsoberfläche die Klebepunkte die metallisch elektrisch leitfähige Abschirmungsoberfläche kontaktieren und dadurch den kontaktsensiblen Oberflächenabschnitt von der Abschirmungsoberfläche beabstanden. D.h. dass die Klebepunkte von dem weitgehend ebenen kontaktsensiblen Oberflächenabschnitt abstehen bzw. ragen sie über diesen zur Sicherstellung eines Mindestabstandes hinaus. Die Anzahl der Klebepunkte kann grundsätzlich frei gewählt werden und wird in der Praxis für die jeweilige Größe des kontaktsensiblen Oberflächenabschnitts optimiert. Beispielhaft sei eine Anzahl von zumindest oder genau zwei, vier, sechs, zehn, zwanzig oder vierzig Klebepunkten genannt. Natürlich können Klebepunkte auch außerhalb des ebenen kontaktsensiblen Oberflächenabschnitts angeordnet sein bzw. über diesen hinaus an der Schaltungsanordnung angebracht werden.

Insbesondere kann vorgesehen sein, dass benachbarte Klebepunkte in einem Sollabstand zwischen 1,5mm und 8mm, insbesondere zwischen 2mm und 6mm, zueinander angeordnet sind. Dieser Abstand wird von der Mitte der jeweiligen Klebepunkte gemessen. Auf diese Weise wird sichergestellt, dass eine günstige Anzahl an Klebepunkten pro Flächeneinheit angeordnet ist. Weiters kann nämlich vorgesehen sein, dass die Klebepunkte weitgehend gleichmäßig entlang dem kontaktsensiblen Oberflächenabschnitt verteilt sind, indem jede gedachte kreisrunde Flächeneinheit des kontaktsensiblen Oberflächenabschnitts, die einen Durchmesser in Höhe des Maximalwerts des Sollabstands aufweist, zumindest einen Klebepunkt aufweist. Das bedeutet, dass der gesamte ebene Oberflächenabschnitt, der kontaktsensibel ist, Klebepunkte aufweist bzw. diese Klebepunkte an dem gesamten ebenen Oberflächenabschnitt verteilt sind.

Insbesondere kann vorgesehen sein, dass die Klebepunkte in Reihen und Spalten angeordnet sind, wobei die Anzahl der Reihen zwischen zwei und vier und die Anzahl der Spalten zwischen acht und sechzehn liegt. Diese Reihen und Spalten entsprechend geraden Linien, wobei die Spalten vorzugsweise orthogonal zu den Reihen orientiert sind und alle Reihen und Spalten innerhalb einer Ebene liegen. Auf diese Weise lässt sich das Dispensieren der Klebepunkte besonders effizient vornehmen.

Weiters kann vorgesehen sein, dass die Höhe der Klebepunkte zwischen 0,05mm und 0,4mm, insbesondere zwischen 0,1mm und 0,25mm beträgt. Insbesondere kann vorgesehen sein, dass der Durchmesser der Klebepunkte im Kontaktbereich mit dem kontaktsensiblen Oberflächenabschnitt zwischen 0,25mm und 1,5mm beträgt. Vorzugsweise haben die Klebepunkte dabei eine kreisrunde Form, und zwar gesehen aus einer Perspektive, die Normal zu der Ebene des Oberflächenabschnitts orientiert ist. Es kann sich dabei um SMT Klebepunkte handeln. Das Verhältnis von Durchmesser zu Höhe des Klebepunkts kann z.B. zwischen 3:1 und 5:1, insbesondere 4:1 betragen, d.h. der Durchmesser ist um ein Vielfaches größer als die Höhe des Klebepunkts. Die Klebepunkte können auch als Abstandshalter zu anderen Elementen wie Blechen, Kühlkörpern, Leiterplatten, Steckern, Deckeln etc. dienen. Der Schaltungsträger kann übrigens im Gehäuse verschraubt sein - auch dadurch können Abstände und Positionen innerhalb eines gewissen Toleranzbereichs gesichert werden. Vorzugsweise werden Schraubverbindungen mit Klebepunkten kombiniert, d.h. ein Bereich der Schaltungsanordnung ist verschraubt während ein anderer Bereich über die Klebepunkte von der Umgebung in einem Mindestabstand beabstandet wird.

Weiters kann vorgesehen sein, dass die Klebepunkte aus wärmehärtendem Klebermaterial bestehen. Beispielshaft sei als wärmehärtendes Klebermaterial der Klebstoff mit der Bezeichnung "Loctite 3621" genannt, der im Handel z.B. über die Henkel Central Eastern Europe GmbH erhältlich ist. Die Schaltungsanordnung mitsamt der daran angeordneten Bauteile und Klebepunkte können z.B. im Zuge eines SMT Prozesses nach der Bestückung zuerst erwärmt werden und dann eine Vorheizzone erreichen, in welcher beispielsweise wärmehärtende Klebepunkte aushärten können und Lötpaste bzw. Lötmaterial noch nicht schmilzt, um vorteilhafterweise sicherzustellen, dass der Kleber härtet bevor das Lötmaterial seine Halte/-Klebekraft verliert. Die Wärmehärtung kann z.B. bei einer Temperatur von 150°C für eine Zeitdauer von z.B. 90 bis 120 Sekunden erfolgen. Nach einer definierten Zeitdauer wird die Temperatur rasch erhöht, um das Lötmaterial rasch zu schmelzen und die elektrischen Bauteile mit zugehörigen Kontaktflächen durch Aufschmelzen von daran angeordnetem Lötmaterial dauerhaft zu verbinden. Nach Ablauf einer definierten Zeitdauer kann im Anschluss die Temperatur wieder gesenkt werden. Die Härtung des Klebers ist somit mit dem Lötvorgang thermisch gekoppelt. So kann beispielsweise vorgesehen sein, dass die Härtetemperatur unterhalb der Schmelztemperatur der Lötverbindung liegt und der Kleber im ausgehärteten Zustand zwischenzeitlich zumindest bis zur Schmelztemperatur der Lötverbindung, insbesondere auf eine Temperatur von 250°C, schadlos erwärmbar ist. Unter dem Ausdruck "schadlos erwärmbar" wird dabei ein Vorgang verstanden, bei dem die mechanischen, thermischen und elektrischen Eigenschaften des Klebers nach der Aushärtung, die unterhalb einer Temperatur von 250°C erfolgt, trotz einer zwischenzeitlichen Erwärmung auf 250°C unverändert aufrechterhalten bleiben. Die Zeitdauer der zwischenzeitlichen Erwärmung beträgt typischerweise einige Sekunden.

Insbesondere kann vorgesehen sein, dass die Schaltungsanordnung durch einen Schaltungsträger und daran angeordnete elektrische Bauteile ausgebildet ist, wobei der kontaktsensible Oberflächenabschnitt durch einen Oberflächenabschnitt des Schaltungsträgers ausgebildet ist, wobei der Schaltungsträger eine Semi-Flex-Leiterplatte ist, die zumindest drei im Wesentlichen starre Abschnitte, nämlich zwei Außenabschnitte und einen Zwischenabschnitt, und zwei flexible Biegeabschnitte umfasst, wobei die beiden Außenabschnitte mit dem Zwischenabschnitt über jeweils einen flexiblen Biegeabschnitt verbunden sind, wobei die Klebepunkte zumindest an dem Zwischenabschnitt angeordnet sind. Auf diese Weise lässt sich durch Biegung, insbesondere Faltung des Schaltungsträgers eine besonders platzsparende Anordnung erzielen. Die Klebepunkte müssen dabei nicht ausschließlich an dem Zwischenabschnitt angeordnet sein, sondern können auch über diesen bis in den Biegeabschnitt hinaus angebracht werden. Unter einer Semi-Flex-Leiterplatten wird eine Leiterplatte verstanden, die flexible und starre Bereiche aufweist. Diese flexiblen Bereiche müssen nicht zwingend dauerhaft flexibel sein. Es kann für die vorliegende Erfindung genügen, wenn der flexible Bereich nach der Bestückung mit den elektrischen Bauteilen zumindest einmal gebogen werden kann, ohne dass dabei die betroffenen Leiterbahnen und/oder Kontakte Schaden nehmen. Ist es z.B. ausreichend, einen nur vorübergehend flexiblen Bereich in der Leiterplatte zu verwenden, z. B. um die Montage bei begrenztem Platz zu ermöglichen, gibt es den Ansatz, einen aus mehreren Prepregs aufgebauten Schichtstapel einer Leiterplatte bis auf wenige Lagen durch Fräsen oder vorgestanzte Prepregs mit ausgesparten Bereichen zu verjüngen. Der verjüngte Bereich wird typischerweise mit einer dauerflexiblen Lackschicht versehen und lässt sich dann wenige Male biegen. Die Leiterplatte kann dadurch trotz Biegungen um 90° oder 180° einstückig ausgebildet werden, wodurch eine platzsparende Bauweise begünstigt wird. Solche Leiterplatten sind z.B. von dem Unternehmen "Würth Elektronik GmbH & Co. KG" erhältlich, siehe z.B. www.we-online.dej flex.

Weiters kann vorgesehen sein, dass zumindest der Zwischenabschnitt gegenüber dem ebenen Abschnitt der Abschirmungsoberfläche des Gehäuses angeordnet ist.

Insbesondere kann vorgesehen sein, dass zwischen den zwei Außenabschnitte eine Öffnung ausgebildet ist, die sich von dem einen Außenabschnitt hin zu dem anderen Außenabschnitt erstreckt, wobei die Öffnung durch die Außenabschnitte, den seitlich angrenzenden Bereich des Zwischenabschnitts und die zwei flexiblen Biegeabschnitte begrenzt ist, wobei in der Abschirmungsoberfläche des Gehäuses eine weitere Öffnung angeordnet ist, die zumindest teilweise mit der Öffnung des Schaltungsträgers überlappt. Diese Öffnung kann z.B. zur Aufnahme eines Steckers bzw. von außen zugeführten elektrischen Leitungen vorgesehen sein.

Weiters kann vorgesehen sein, dass der Schaltungsträger zusätzlich einen starren Zusatzaußenabschnitt sowie einen zusätzlichen flexiblen Biegeabschnitt aufweist, mit dem der Zusatzaußenabschnitt mit einem der Außenabschnitte flexibel verbunden ist. Die Biegungen in den Biegeabschnitten können z.B. jeweils 90° betragen, wobei vorzugsweise Rundungen mit konstantem Biegeradius vorgesehen sind, um kritische Minima im Biegeradius zu vermeiden.

Insbesondere kann vorgesehen sein, dass die Schaltungsanordnung Lichtquellen, insbesondere LED-Lichtquellen, zur Abstrahlung von Licht umfasst. Die Lichtquellen können dazu vorgesehen sein im Zusammenwirken mit einem nachgeschalteten Projektionssystem die den bereits genannten Lichtfunktionen entsprechenden Lichtverteilungen abzustrahlen.

Weiters kann vorgesehen sein, dass der kontaktsensible Oberflächenabschnitt und der ebene Abschnitt der Abschirmungsoberfläche parallel zueinander orientiert sind.

Insbesondere kann vorgesehen sein, dass der Abstand zwischen der kontaktsensible Oberflächenabschnitt und dem ebenen Abschnitt der Abschirmungsoberfläche maximal 5mm beträgt. Die Bauweise ist damit besonders kompakt.

Weiters betrifft die Erfindung einen Fahrzeugscheinwerfer, insbesondere einen Kraftfahrzeugscheinwerfer, umfassend ein erfindungsgemäßes Fahrzeugscheinwerfermodul sowie zumindest ein optisches Projektionssystem zur Abstrahlung einer Lichtverteilung.

Die Erfindung ist im Folgenden anhand einer beispielhaften und nicht einschränkenden Ausführungsform näher erläutert, die in den Figuren veranschaulicht ist. Darin zeigt
Figur 1 eine perspektivische Darstellung eines erfindungsgemäßen Fahrzeugscheinwerfermoduls,
Figur 2 eine perspektivische Darstellung des Fahrzeugscheinwerfermoduls gemäß Fig. 1 ohne ein daran angeordnetes Gehäuse,
Figur 3 eine Seitenansicht auf das Fahrzeugscheinwerfermodul gemäß Fig. 1 und 2,
Figur 4 eine Detailansicht des Fahrzeugscheinwerfermoduls gemäß Fig. 1 bis 3,
Figur 5 eine Detailansicht einer Schaltungsanordnung eines Fahrzeugscheinwerfermoduls gemäß Fig. 1 bis 4 mit daran angeordneten Klebepunkten in einem nicht eingebauten Zustand,
Figur 6 eine weitere Detailansicht einer Schaltungsanordnung,
Figur 7 eine Schnittdarstellung eines Schaltungsträgers mit einem daran angeordneten Klebepunkt, und
Figur 8 eine schematische Darstellung eines Fahrzeugscheinwerfers umfassend ein erfindungsgemäßes Fahrzeugscheinwerfermodul.

In den folgenden Figuren bezeichnen - sofern nicht anders angegeben - gleiche Bezugszeichen gleiche Merkmale.

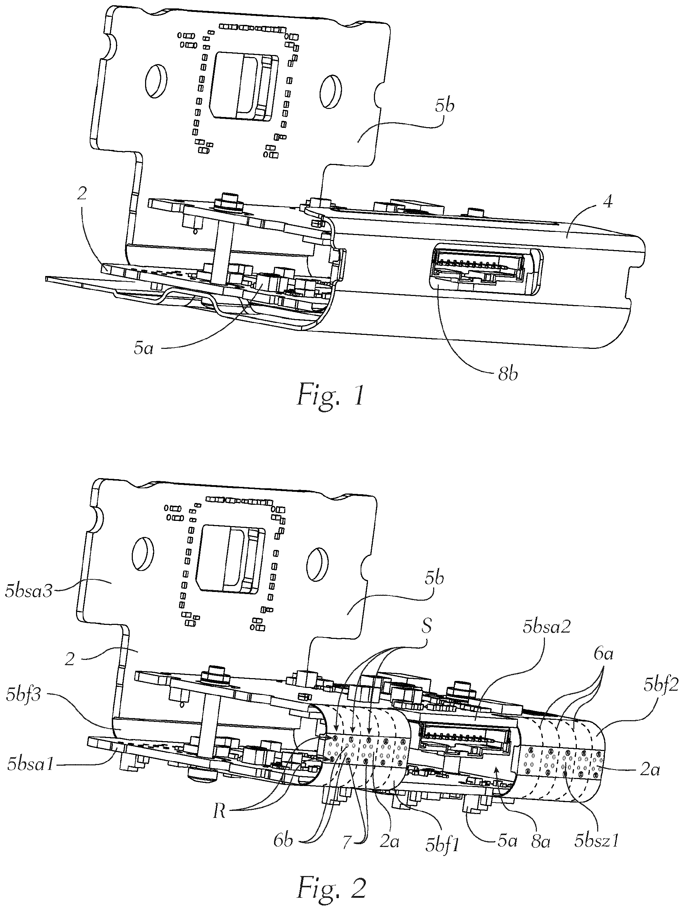

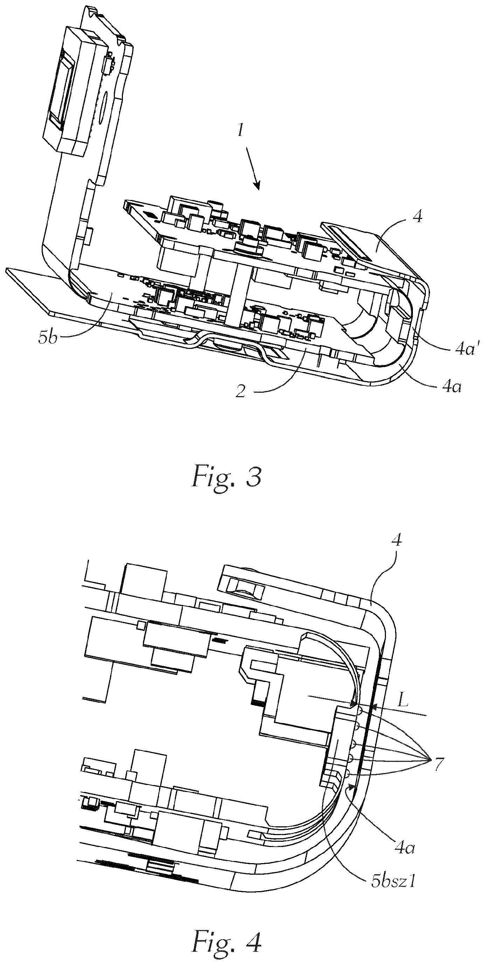

Figur 1 zeigt eine perspektivische Darstellung eines erfindungsgemäßen Fahrzeugscheinwerfermoduls 1. Das Fahrzeugscheinwerfermodul 1 umfasst eine elektrische Schaltungsanordnung 2 zur Steuerung zumindest einer Funktion eines Fahrzeugscheinwerfers 3, sowie ein Gehäuse 4 zur zumindest teilweisen Aufnahme der elektrischen Schaltungsanordnung 2. Das Gehäuse 4 weist zumindest abschnittsweise eine der Schaltungsanordnung 2 zugewandte metallische elektrisch leitfähige Abschirmungsoberfläche 4a (siehe Fig. 3) zur elektromagnetischen Abschirmung der Schaltungsanordnung 2 auf.

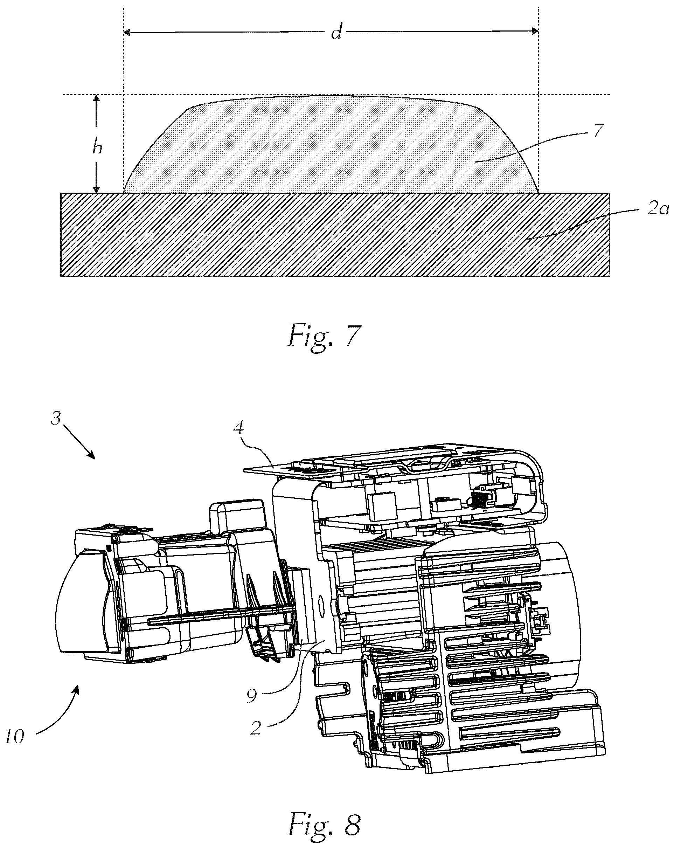

Mit Blick auf Fig. 2 sei erwähnt, dass die elektrische Schaltungsanordnung 2 zumindest einen weitgehend eben ausgebildeten kontaktsensiblen Oberflächenabschnitt 2a aufweist. Dieser kontaktsensible Oberflächenabschnitt 2a ist frei von daran angeordneten elektrischen Bauteilen 5a. Zudem ist der Abschnitt 2a einem ebenen Abschnitt 4a' (siehe Fig. 3) der Abschirmungsoberfläche 4a des Gehäuses 4 zugewandt, wobei elektrische Leiterbahnen 6a und/oder Kontakte 6b entlang dem kontaktsensiblen Oberflächenabschnitt 2a verlaufen. An dem weitgehend eben ausgebildeten kontaktsensiblen Oberflächenabschnitt 2a ist eine Anzahl ausgehärteter elektrisch nicht leitfähiger Klebepunkte 7 angeordnet, die von dem kontaktsensiblen Oberflächenabschnitt 2a zur Sicherstellung eines Mindestabstandes zwischen dem kontaktsensiblen Oberflächenabschnitt 2a und dem ebenen Abschnitt 4a' der Abschirmungsoberfläche 4a des Gehäuses 4 in Richtung des ebenen Abschnitts 4a' der Abschirmungsoberfläche 4a des Gehäuses 4 abstehen. Der Mindestabstand kann der Höhe h der Klebepunkte 7 entsprechen, die vorzugsweise zwischen 0,05mm und 0,4mm, insbesondere zwischen 0,1mm und 0,25mm beträgt (siehe Fig. 7). Es kann vorgesehen sein, dass benachbarte Klebepunkte 7 in einem Sollabstand zwischen 1,5mm und 8mm, insbesondere zwischen 2mm und 6mm, zueinander angeordnet sind.

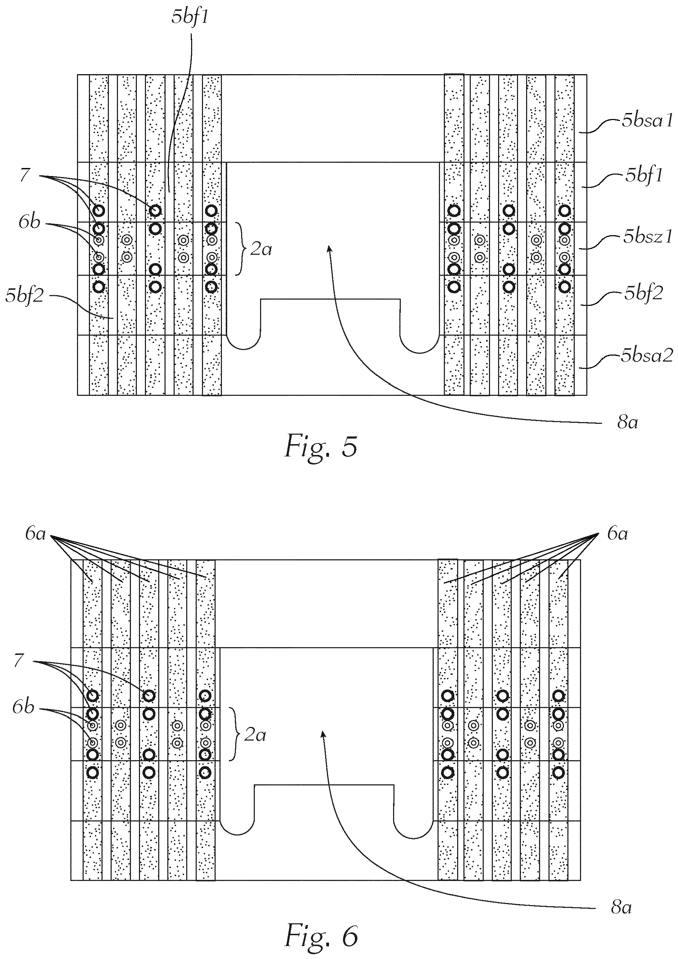

In Fig. 2 ist zudem erkennbar, dass die Klebepunkte 7 in Reihen R und Spalten S (siehe auch Fig. 5) angeordnet sind, wobei die Anzahl der Reihen R zwischen zwei und vier und die Anzahl der Spalten S zwischen acht und sechzehn beträgt. Die Schaltungsanordnung 2 wird durch einen Schaltungsträger 5b und daran angeordnete elektrische Bauteile 5a ausgebildet. Der kontaktsensible Oberflächenabschnitt 2a wird durch einen Oberflächenabschnitt des Schaltungsträgers 5b ausgebildet, wobei der Schaltungsträger 5b eine Semi-Flex-Leiterplatte ist, die zumindest drei im Wesentlichen starre Abschnitte, nämlich zwei Außenabschnitte 5bsa1 und 5bsa2 und einen Zwischenabschnitt 5bsz1, und zwei flexible Biegeabschnitte 5bf1 und 5bf2 umfasst. Die beiden Außenabschnitte 5bsa1 und 5bsa2 sind mit dem Zwischenabschnitt 5bsz1 über jeweils einen flexiblen Biegeabschnitt 5bf1 und 5bf2 verbunden. Die Klebepunkte 7 sind zumindest an dem Zwischenabschnitt 5bsz1 angeordnet und können auch darüber hinaus an dem Schaltungsträger 2a angebracht sein. In Fig. 3 und Fig. 4 ist gut erkennbar, dass der Zwischenabschnitt 5bsz1 gegenüber dem ebenen Abschnitt 4a' der Abschirmungsoberfläche 4a des Gehäuses 4 angeordnet ist. Insbesondere sind diese zwei Abschnitte 5bsz1 und 4a' parallel zueinander angeordnet. Es kann vorgesehen sein, dass ein Abstand L zwischen der kontaktsensible Oberflächenabschnitt 2a und dem ebenen Abschnitt 4a' der Abschirmungsoberfläche 4a maximal 5mm beträgt.

Fig. 5 zeigt eine Detailansicht einer Schaltungsanordnung 2 eines Fahrzeugscheinwerfermoduls 1 gemäß Fig. 1 bis 4 mit daran angeordneten Klebepunkten 7 in einem nicht eingebauten ungefalteten Zustand. Darin ist erkennbar, dass zwischen den zwei Außenabschnitte 5bsa1, 5bsa2 eine Öffnung 8a (siehe auch Fig. 2) ausgebildet ist, die sich von dem einen Außenabschnitt 5bsa1 hin zu dem anderen Außenabschnitt 5bsa2 erstreckt. Die Öffnung 8a wird durch die Außenabschnitte 5bsa1 und 5bsa2 und den seitlich angrenzenden Bereichen des Zwischenabschnitts 5bsz1 und der zwei flexiblen Biegeabschnitte 5bf1 und 5bf2 begrenzt. In der Abschirmungsoberfläche 4a des Gehäuses 4 ist eine weitere Öffnung 8b angeordnet, die zumindest teilweise mit der Öffnung 8a des Schaltungsträgers 5b überlappt.

Mit Blick auf Fig. 2 sei erwähnt, dass der Schaltungsträger 5b zusätzlich einen starren Zusatzaußenabschnitt 5bsa3 sowie einen zusätzlichen flexiblen Biegeabschnitt 5bf3 aufweist, mit dem der Zusatzaußenabschnitt 5bsa3 mit einem der Außenabschnitte 5bsa2 (zumindest zwischenzeitlich) flexibel verbunden ist. Im Zusammenhang mit der vorliegenden Erfindung bedeutet der Ausdruck "flexibel", dass das betreffende Element zumindest vorübergehend flexibel ist und gebogen werden kann, ohne dabei Schaden zu nehmen. Im Extremfall ist eine einmalige schadlose Biegung ausreichend.

Figur 7 zeigt eine Schnittdarstellung eines Schaltungsträgers 2 mit einem daran angeordneten Klebepunkt 7. Der Durchmesser d der Klebepunkte 7 im Kontaktbereich mit dem kontaktsensiblen Oberflächenabschnitt 2a beträgt zwischen 0,25mm und 1,5mm. Es kann vorgesehen sein, dass die Klebepunkte 7 aus wärmehärtendem Klebermaterial bestehen.

Fig. 8 zeigt eine schematische Darstellung eines Fahrzeugscheinwerfers 3. Der Fahrzeugscheinwerfer 3, insbesondere Kraftfahrzeugscheinwerfer, umfasst ein erfindungsgemäßes Fahrzeugscheinwerfermodul 1 sowie zumindest ein optisches Projektionssystem 10 zur Abstrahlung einer Lichtverteilung. Die Schaltungsanordnung 2 kann Lichtquellen 9, insbesondere LED-Lichtquellen, zur Abstrahlung von Licht umfassen.

Die Erfindung ist nicht auf die gezeigten Ausführungsformen beschränkt, sondern durch den gesamten Schutzumfang der Ansprüche definiert. Etwaige Bezugszeichen in den Ansprüchen sind beispielhaft und dienen nur der einfacheren Lesbarkeit der Ansprüche, ohne diese einzuschränken.

## Patentansprüche

1. Fahrzeugscheinwerfermodul (1), umfassend
- eine elektrische Schaltungsanordnung (2) zur Steuerung zumindest einer Funktion eines Fahrzeugscheinwerfers (3), sowie
- ein Gehäuse (4) zur zumindest teilweisen Aufnahme der elektrischen Schaltungsanordnung (2), wobei das Gehäuse (4) zumindest abschnittsweise eine der Schaltungsanordnung (2) zugewandte metallische elektrisch leitfähige Abschirmungsoberfläche (4a) zur elektromagnetischen Abschirmung der Schaltungsanordnung (2) aufweist,
wobei die elektrische Schaltungsanordnung (2) zumindest einen weitgehend eben ausgebildeten kontaktsensiblen Oberflächenabschnitt (2a) aufweist, wobei dieser kontaktsensible Oberflächenabschnitt (2a) frei von daran angeordneten elektrischen Bauteilen (5a) ist und einem ebenen Abschnitt (4a') der Abschirmungsoberfläche (4a) des Gehäuses (4) zugewandt ist, wobei elektrische Leiterbahnen (6a) und/oder Kontakte (6b) entlang dem kontaktsensiblen Oberflächenabschnitt (2a) verlaufen,
**dadurch gekennzeichnet, dass**
an dem weitgehend eben ausgebildeten kontaktsensiblen Oberflächenabschnitt (2a) eine Anzahl ausgehärteter elektrisch nicht leitfähiger Klebepunkte (7) angeordnet ist, die von dem kontaktsensiblen Oberflächenabschnitt (2a) zur Sicherstellung eines Mindestabstandes zwischen dem kontaktsensiblen Oberflächenabschnitt (2a) und dem ebenen Abschnitt (4a') der Abschirmungsoberfläche (4a) des Gehäuses (4) in Richtung des ebenen Abschnitts (4a') der Abschirmungsoberfläche (4a) des Gehäuses (4) abstehen.

2. Fahrzeugscheinwerfermodul (1) nach Anspruch 1, wobei benachbarte Klebepunkte (7) in einem Sollabstand zwischen 1,5mm und 8mm, insbesondere zwischen 2mm und 6mm, zueinander angeordnet sind.

3. Fahrzeugscheinwerfermodul (1) nach Anspruch 2, wobei die Klebepunkte (7) weitgehend gleichmäßig entlang dem kontaktsensiblen Oberflächenabschnitt (2a) verteilt sind, indem jede gedachte kreisrunde Flächeneinheit des kontaktsensiblen Oberflächenabschnitts (2a), die einen Durchmesser in Höhe des Maximalwerts des Sollabstands aufweist, zumindest einen Klebepunkt (7) aufweist.

4. Fahrzeugscheinwerfermodul (1) nach einem der vorhergehenden Ansprüche, wobei die Klebepunkte (7) in Reihen (R) und Spalten (S) angeordnet sind, wobei die Anzahl der Reihen (R) zwischen zwei und vier und die Anzahl der Spalten (S) zwischen acht und sechzehn liegt.

5. Fahrzeugscheinwerfermodul (1) nach einem der vorhergehenden Ansprüche, wobei die Höhe (h) der Klebepunkte (7) zwischen 0,05mm und 0,4mm, insbesondere zwischen 0,1mm und 0,25mm beträgt.

6. Fahrzeugscheinwerfermodul (1) nach einem der vorhergehenden Ansprüche, wobei der Durchmesser (d) der Klebepunkte (7) im Kontaktbereich mit dem kontaktsensiblen Oberflächenabschnitt (2a) zwischen 0,25mm und 1,5mm beträgt

7. Fahrzeugscheinwerfermodul (1) nach einem der vorhergehenden Ansprüche, wobei die Klebepunkte (7) aus wärmehärtendem Klebermaterial bestehen.

8. Fahrzeugscheinwerfermodul (1) nach einem der vorhergehenden Ansprüche, wobei die Schaltungsanordnung (2) durch einen Schaltungsträger (5b) und daran angeordnete elektrische Bauteile (5a) ausgebildet ist, wobei der kontaktsensible Oberflächenabschnitt (2a) durch einen Oberflächenabschnitt des Schaltungsträgers (5b) ausgebildet ist, wobei der Schaltungsträger (5b) eine Semi-Flex-Leiterplatte ist, die zumindest drei im Wesentlichen starre Abschnitte, nämlich zwei Außenabschnitte (5bsa1, 5bsa2) und einen Zwischenabschnitt (5bsz1), und zwei flexible Biegeabschnitte (5bf1, 5bf2) umfasst, wobei die beiden Außenabschnitte (5bsa1, 5bsa2) mit dem Zwischenabschnitt (5bsz1) über jeweils einen flexiblen Biegeabschnitt (5bf1, 5bf2) verbunden sind, wobei die Klebepunkte (7) zumindest an dem Zwischenabschnitt (5bsz1) angeordnet sind.

9. Fahrzeugscheinwerfermodul (1) nach Anspruch 8, wobei zumindest der Zwischenabschnitt (5bsz1) gegenüber dem ebenen Abschnitt (4a') der Abschirmungsoberfläche (4a) des Gehäuses (4) angeordnet ist.

10. Fahrzeugscheinwerfermodul (1) nach Anspruch 8 oder 9, wobei zwischen den zwei Außenabschnitte (5bsa1, 5bsa2) eine Öffnung (8a) ausgebildet ist, die sich von dem einen Außenabschnitt (5bsa1) hin zu dem anderen Außenabschnitt (5bsa2) erstreckt, wobei die Öffnung (8a) durch die Außenabschnitte (5bsa1, 5bsa2) und seitlich angrenzende Bereich des Zwischenabschnitts (5bsz1) und der zwei flexiblen Biegeabschnitte (5bf1, 5bf2) begrenzt ist, wobei in der Abschirmungsoberfläche (4a) des Gehäuses (4) eine weitere Öffnung (8b) angeordnet ist, die zumindest teilweise mit der Öffnung (8a) des Schaltungsträgers (5b) überlappt.

11. Fahrzeugscheinwerfermodul (1) nach einem der Ansprüche 1 bis 10, wobei der Schaltungsträger (5b) zusätzlich einen starren Zusatzaußenabschnitt (5bsa3) sowie einen zusätzlichen flexiblen Biegeabschnitt (5bf3) aufweist, mit dem der Zusatzaußenabschnitt (5bsa3) mit einem der Außenabschnitte (5bsa2) flexibel verbunden ist.

12. Fahrzeugscheinwerfermodul (1) nach einem der vorhergehenden Ansprüche, wobei die Schaltungsanordnung (2) Lichtquellen (9), insbesondere LED-Lichtquellen, zur Abstrahlung von Licht umfasst.

13. Fahrzeugscheinwerfermodul (1) nach einem der vorhergehenden Ansprüche, wobei der kontaktsensible Oberflächenabschnitt (2a) und der ebene Abschnitt (4a') der Abschirmungsoberfläche (4a) parallel zueinander orientiert sind.

14. Fahrzeugscheinwerfermodul (1) nach einem der vorhergehenden Ansprüche, wobei der Abstand (L) zwischen der kontaktsensible Oberflächenabschnitt (2a) und dem ebenen Abschnitt (4a') der Abschirmungsoberfläche (4a) maximal 5mm beträgt.

15. Fahrzeugscheinwerfer (3), insbesondere Kraftfahrzeugscheinwerfer, umfassend ein Fahrzeugscheinwerfermodul (1) nach einem der vorhergehenden Ansprüche sowie zumindest ein optisches Projektionssystem (10) zur Abstrahlung einer Lichtverteilung.

## Claims

1. Vehicle headlight module (1), comprising
- an electrical circuit arrangement (2) for controlling at least one function of a vehicle headlamp (3), and
- a housing (4) for at least partially accommodating the electrical circuit arrangement (2), the housing (4) having, at least in sections, a metallic electrically conductive shielding surface (4a) facing the circuit arrangement (2) for electromagnetic shielding of the circuit arrangement (2),
the electrical circuit arrangement (2) having at least one contact-sensitive surface section (2a) which is designed to be largely flat, this contact-sensitive surface section (2a) being free of electrical components (5a) arranged thereon and facing a flat section (4a') of the shielding surface (4a) of the housing (4), electrical conductor tracks (6a) and/or contacts (6b) running along the contact-sensitive surface section (2a),
**characterized in that**
a number of cured electrically non-conductive adhesive dots (7) is arranged on the substantially flat contact-sensitive surface section (2a), which adhesive dots (7) project from the contact-sensitive surface section (2a) in the direction of the flat section (4a') of the shielding surface (4a) of the housing (4) in order to ensure a minimum distance between the contact-sensitive surface section (2a) and the flat section (4a') of the shielding surface (4a) of the housing (4).

2. Vehicle headlight module (1) according to claim 1, wherein adjacent adhesive dots (7) are arranged at a nominal distance of between 1.5 mm and 8 mm, in particular between 2 mm and 6 mm, from one another.

3. Vehicle headlight module (1) according to claim 2, wherein the adhesive dots (7) are distributed largely uniformly along the contact-sensitive surface section (2a) in that each imaginary circular surface unit of the contact-sensitive surface section (2a), which has a diameter at the level of the maximum value of the nominal spacing, has at least one adhesive dot (7).

4. Vehicle headlight module (1) according to one of the preceding claims, wherein the adhesive dots (7) are arranged in rows (R) and columns (S), wherein the number of rows (R) is between two and four and the number of columns (S) is between eight and sixteen.

5. Vehicle headlight module (1) according to one of the preceding claims, wherein the height (h) of the adhesive dots (7) is between 0.05mm and 0.4mm, in particular between 0.1mm and 0.25mm.

6. Vehicle headlight module (1) according to one of the preceding claims, wherein the diameter (d) of the adhesive dots (7) in the contact region with the contact-sensitive surface portion (2a) is between 0.25mm and 1.5mm

7. Vehicle headlight module (1) according to one of the preceding claims, wherein the adhesive dots (7) consist of thermosetting adhesive material.

8. Vehicle headlight module (1) according to one of the preceding claims, wherein the circuit arrangement (2) is formed by a circuit carrier (5b) and electrical components (5a) arranged thereon, wherein the contact-sensitive surface portion (2a) is formed by a surface portion of the circuit carrier (5b), wherein the circuit carrier (5b) is a semi-flex printed circuit board which comprises at least three substantially rigid sections, namely two outer sections (5bsa1, 5bsa2) and an intermediate section (5bsz1), and two flexible bending sections (5bf1, 5bf2), the two outer sections (5bsa1, 5bsa2) being connected to the intermediate section (5bsz1) via in each case one flexible bending section (5bf1, 5bf2), the adhesive dots (7) being arranged at least on the intermediate section (5bsz1).

9. Vehicle headlight module (1) according to claim 8, wherein at least the intermediate portion (5bsz1) is arranged opposite the flat portion (4a') of the shielding surface (4a) of the housing (4).

10. Vehicle headlight module (1) according to claim 8 or 9, wherein an opening (8a) is formed between the two outer portions (5bsa1, 5bsa2) and extends from the one outer portion (5bsa1) towards the other outer portion (5bsa2), wherein the opening (8a) passes through the outer portions (5bsa1, 5bsa2) and laterally adjoining region of the intermediate portion (5bsz1) and the two flexible bending portions (5bf1, 5bf2), wherein a further opening (8b) is arranged in the shielding surface (4a) of the housing (4), which at least partially overlaps with the opening (8a) of the circuit carrier (5b).

11. Vehicle headlight module (1) according to one of claims 1 to 10, wherein the circuit carrier (5b) additionally comprises a rigid additional outer section (5bsa3) as well as an additional flexible bending section (5bf3), with which the additional outer section (5bsa3) is flexibly connected to one of the outer sections (5bsa2).

12. Vehicle headlight module (1) according to one of the preceding claims, wherein the circuit arrangement (2) comprises light sources (9), in particular LED light sources, for emitting light.

13. Vehicle headlight module (1) according to one of the preceding claims, wherein the contact-sensitive surface portion (2a) and the planar portion (4a') of the shielding surface (4a) are oriented parallel to each other.

14. Vehicle headlight module (1) according to one of the preceding claims, wherein the distance (L) between the contact-sensitive surface portion (2a) and the planar portion (4a') of the shielding surface (4a) is at most 5mm.

15. Vehicle headlight (3), in particular motor vehicle headlight, comprising a vehicle headlight module (1) according to one of the preceding claims and at least one optical projection system (10) for emitting a light distribution.

## Revendications

1. Module de projecteur de véhicule (1), comprenant
- un circuit électrique (2) pour commander au moins une fonction d'un phare de véhicule (3), ainsi que
- un boîtier (4) destiné à recevoir au moins partiellement l'agencement de circuit électrique (2), le boîtier (4) présentant au moins par sections une surface de blindage métallique électriquement conductrice (4a) tournée vers l'agencement de circuit (2) pour le blindage électromagnétique de l'agencement de circuit (2),
le dispositif de circuit électrique (2) présentant au moins une section de surface (2a) sensible aux contacts, réalisée de manière largement plane, cette section de surface (2a) sensible aux contacts étant exempte de composants électriques (5a) disposés sur celle-ci et étant tournée vers une section plane (4a') de la surface de blindage (4a) du boîtier (4), des pistes conductrices électriques (6a) et/ou des contacts (6b) s'étendant le long de la section de surface (2a) sensible aux contacts,
**caractérisé en ce que**
un certain nombre de points de collage (7) durcis et non conducteurs de l'électricité sont disposés sur la partie de surface (2a) sensible au contact, qui dépassent de la partie de surface (2a) sensible au contact pour assurer une distance minimale entre la partie de surface (2a) sensible au contact et la partie plane (4a') de la surface de blindage (4a) du boîtier (4) en direction de la partie plane (4a') de la surface de blindage (4a) du boîtier (4).

2. Module de projecteur de véhicule (1) selon la revendication 1, dans lequel des points de collage (7) voisins sont disposés à une distance théorique comprise entre 1,5mm et 8mm, en particulier entre 2mm et 6mm.

3. Module de projecteur de véhicule (1) selon la revendication 2, dans lequel les points de collage (7) sont répartis de manière largement uniforme le long de la section de surface sensible au contact (2a), en ce que chaque unité de surface circulaire imaginaire de la section de surface sensible au contact (2a), qui présente un diamètre égal à la valeur maximale de la distance de consigne, présente au moins un point de collage (7).

4. Module de projecteur de véhicule (1) selon l'une quelconque des revendications précédentes, dans lequel les points de collage (7) sont disposés en rangées (R) et en colonnes (S), le nombre de rangées (R) étant compris entre deux et quatre et le nombre de colonnes (S) étant compris entre huit et seize.

5. Module de projecteur de véhicule (1) selon l'une quelconque des revendications précédentes, dans lequel la hauteur (h) des points de collage (7) est comprise entre 0,05mm et 0,4mm, notamment entre 0,1mm et 0,25mm.

6. Module de projecteur de véhicule (1) selon l'une quelconque des revendications précédentes, dans lequel le diamètre (d) des points de collage (7) dans la zone de contact avec la portion de surface sensible au contact (2a) est compris entre 0,25mm et 1,5mm.

7. Module de projecteur de véhicule (1) selon l'une quelconque des revendications précédentes, dans lequel les points de collage (7) sont constitués d'un matériau adhésif thermodurcissable.

8. Module de projecteur de véhicule (1) selon l'une des revendications précédentes, dans lequel l'agencement de circuit (2) est formé par un support de circuit (5b) et des composants électriques (5a) disposés sur celui-ci, la partie de surface sensible au contact (2a) étant formée par une partie de surface du support de circuit (5b), le support de circuit (5b) étant une carte à circuit imprimé semi-flexible, qui comprend au moins trois parties sensiblement rigides, à savoir deux parties extérieures (5bsa1, 5bsa2) et une partie intermédiaire (5bsz1), et deux parties flexibles de flexion (5bf1, 5bf2), les deux parties extérieures (5bsa1, 5bsa2) étant reliées à la partie intermédiaire (5bsz1) par l'intermédiaire d'une partie flexible de flexion (5bf1, 5bf2) respective, les points de collage (7) étant disposés au moins sur la partie intermédiaire (5bsz1).

9. Module de projecteur de véhicule (1) selon la revendication 8, dans lequel au moins la partie intermédiaire (5bsz1) est disposée en regard de la partie plane (4a') de la surface de blindage (4a) du boîtier (4).

10. Module de projecteur de véhicule (1) selon la revendication 8 ou 9, dans lequel une ouverture (8a) est formée entre les deux parties extérieures (5bsa1, 5bsa2) et s'étend depuis une partie extérieure (5bsa1) vers l'autre partie extérieure (5bsa2), l'ouverture (8a) traversant les parties extérieures (5bsa1, 5bsa2) et des zones latéralement adjacentes de la partie intermédiaire (5bsz1) et des deux parties flexibles de flexion (5bf1, 5bf2), une autre ouverture (8b) étant disposée dans la surface de blindage (4a) du boîtier (4) et chevauchant au moins partiellement l'ouverture (8a) du support de circuit (5b).

11. Module de projecteur de véhicule (1) selon l'une quelconque des revendications 1 à 10, dans lequel le support de circuit (5b) comporte en outre une partie extérieure supplémentaire rigide (5bsa3) ainsi qu'une partie flexible supplémentaire de flexion (5bf3) par laquelle la partie extérieure supplémentaire (5bsa3) est reliée de manière flexible à l'une des parties extérieures (5bsa2).

12. Module de projecteur de véhicule (1) selon l'une des revendications précédentes, dans lequel le circuit (2) comprend des sources lumineuses (9), notamment des sources lumineuses LED, pour émettre de la lumière.

13. Module de projecteur de véhicule (1) selon l'une des revendications précédentes, dans lequel la portion de surface sensible au contact (2a) et la portion plane (4a') de la surface de blindage (4a) sont orientées parallèlement l'une à l'autre.

14. Module de projecteur de véhicule (1) selon l'une des revendications précédentes, dans lequel la distance (L) entre la portion de surface sensible au contact (2a) et la portion plane (4a') de la surface de blindage (4a) est au maximum de 5mm.

15. Projecteur de véhicule (3), notamment projecteur de véhicule automobile, comprenant un module de projecteur de véhicule (1) selon l'une des revendications précédentes ainsi qu'au moins un système optique de projection (10) pour émettre une répartition de lumière.
